# EUROPEAN PATENT APPLICATION

(11) **EP 2 434 528 A1**
(43) Date of publication of application: **28.03.2012**
(21) Application number: 10180955.6
(22) Date of filing: 28.09.2010
(51) Int. Cl.: H01L 21/00, H05B 3/00

(54) **An active carrier for carrying a wafer and method for release**

(71) Applicant: Nederlandse Organisatie voor Toegepast -Natuurwetenschappelijk Onderzoek TNO, 2628 VK Delft (NL)
(72) Inventor: Oosterhuis, Gerrit, 2628 VK Delft (NL); van der Zon, Clemens Maria Bernardus, 2628 VK Delft (NL); Bullema, Jan Eite, 2628 VK Delft (NL); Timmer, Klaas, 2628 VK Delft (NL); Fischer, Hartmut Rudolf, 2628 VK Delft (NL); Burghoorn, Maria Mathea Antonetta, 2628 VK Delft (NL)
(74) Representative: Jansen, Cornelis Marinus

(57) **Abstract**

In the field of release and pickup of ultrathin semiconductor dies, there is provided an active carrier (1) for carrying a wafer (20) and a method for using such a carrier (1). The wafer (20) comprises a particular die arrangement (P). The active carrier (1) comprises a base plate (2) and a number of energizers (7) constructed on or in this base plate (2). The energizers (7) are laid out in an arrangement corresponding to the die arrangement (P). The energizers (7) can locally energize an adhesive layer (3) in proximity to a selected die (14) from the die arrangement (P). By this local energizing of the adhesive layer (P), the selected die is loosened from the adhesive layer (3). Furthermore the active carrier (1) comprises a plurality of externally addressable contacts (12) and conduction pathways (9). The conduction pathways (9) connect the contacts (12) to the energizers (7) thereby allowing individual control over said energizers (7) by addressing said contacts (12).

## Description

### FIELD OF INVENTION

This invention relates to an active carrier for dies.

This invention further relates to a method for release and pickup of dies involving the use of an active carrier

### BACKGROUND OF INVENTION

Typically, integrated circuits (ICs) are produced in large batches arranged on a single wafer through processes such as photolithography. This arrangement is subsequently separated into pieces called "dies". The arrangement of the dies on the wafer (both before and after cutting) will be referred to as the die arrangement P.

In the ongoing miniaturization process of IC devices, the latest developments involve the manufacture of stacks with multiple ultrathin silicon dies, also referred to as 3D stacking. Stacking is conventionally done with dies with a thickness of greater than approximately 100 micrometer.

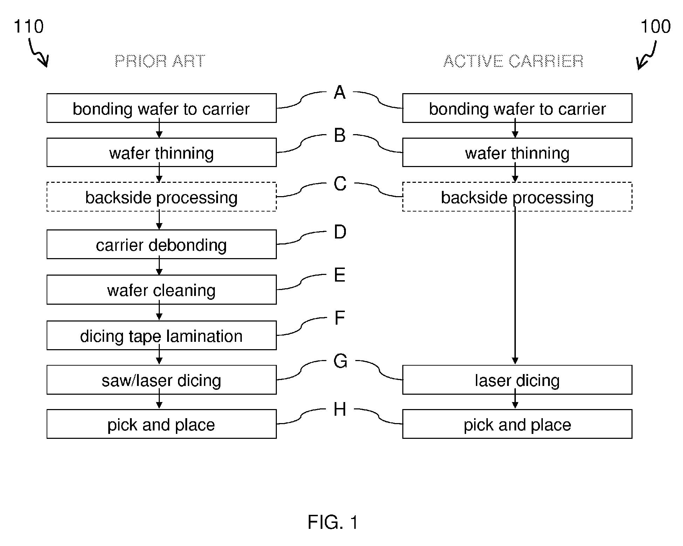

FIG 1 shows on the left side a conventional process for transforming a (thick) wafer, with circuits formed, into a plurality of thin dies, suitable for 3D stacking, comprising the following steps:
A) A wafer is bonded with its front (circuit) side to a carrier which is layered with a temporary adhesive, conventionally wax or thermoplastic;
B) The wafer is thinned (from the backside) through processes such as grinding, while being held by the carrier;
C) The thinned wafer is optionally further processed from the backside, e.g. for the creation of vertical connections such as Through Silicon Vias (TSVs);
D) The thinned wafer is detached/ released from the carrier, e.g. by heating;
E) The thinned wafer is cleaned;
F) The thinned wafer is stuck onto a dicing tape to allow for cutting of the thinned wafer.
G) The thinned wafer is cut ("diced") by a saw or laser into individual dies (leaving the tape intact).
H) The (thin) dies are picked up from the dicing tape and placed in a destination position, e.g. a 3D stack.

All these different steps add to the cost of ownership (CoO) of the wafer processing machine. E.g. it is estimated that steps D - F add about 16 Euro per wafer to the CoO. Currently CoO of thin wafer handling is one of the main obstacles that prevent 3D integration from reaching its full market potential.

An additional obstacle arises when removing the dies from the dicing tape (step H). This dicing tape needs to have a high adhesion to reliably prevent positioning errors of the semiconductor wafer. However, if the adhesion is set too high it becomes difficult to separate the obtained semiconductor dies from the adhesive tape. Traditional pick-up methods for separating the semiconductor dies from the tape are based on the fact that the stiffness of the die is much higher than the stiffness of the carrier tape.

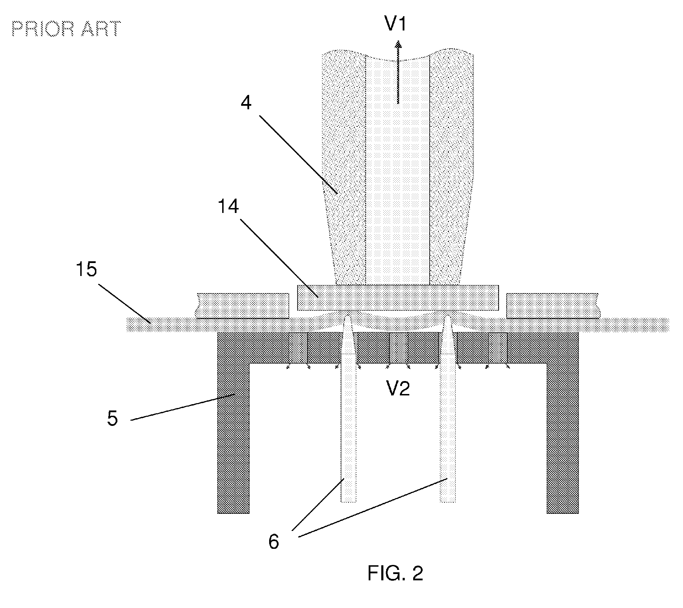

FIG 2 shows the pick-up of a thin die carried out with the help of a lifting needle that pushes through the tape against the die. This pushing action creates stresses at the die edge that initiate peeling. First the chip is attached to a pickup tool through vacuum and then separated (peeled) from the adhesive tape. The pushing action of the needles is required as the vacuum force alone is not strong enough to overcome the adhesion and 'squeeze-flow' forces. However, the pushing forces as well as the edge stresses as a result of the pushing needle only occur when the bending stiffness of the die is substantially higher than the bending stiffness of the foil. Following the current trend for using ever thinner dies, e.g. down to 20 micrometers this is no longer valid.

Using slower peel speeds can help, but this will increase the cycle time and reduce productivity, resulting in increased CoO. Further reducing chip thickness or increasing the size will result in a greater chance of the chip breaking during peeling, again increasing CoO. Also, even if the adhesive can be deactivated, the remaining fluid layer below the die will cause squeeze flow effects that - at relevant pick-up speeds - yield a required pick-up force that is much higher than what can be applied by a vacuum nozzle. Hence other devices and/or methods for pick-up are necessary when going to thinner die thicknesses, especially down to 20 micrometers.

### SUMMARY OF INVENTION

In a first aspect there is provided an active carrier for carrying a wafer. The wafer comprises a particular die arrangement. The carrier comprises a base plate and a number of energizers constructed on or in this base plate. The energizers are laid out in an arrangement corresponding to the die arrangement. The energizers can locally energize an adhesive layer in proximity to a selected die from the die arrangement. By this local energizing of the adhesive layer, the die is loosened from the adhesive layer. Furthermore the active carrier comprises a plurality of externally addressable contacts and conduction pathways. The conduction pathways connect the contacts to the energizers thereby allowing individual control over said energizers by addressing said contacts.

In a second aspect there is provided a method for active release and pickup of a plurality of dies. For this, there is provided an active carrier according to the first aspect of the invention additionally comprising an adhesive layer. Furthermore a pickup tool, a controller and a plurality of dies are provided. These dies are adhered to said adhesive layer of the carrier and laid out in a particular die arrangement. The steps of active release and pickup comprise the following steps in any order. In the active release step, the controller is used to activate at least one energizer in proximity to a selected die from said die arrangement. The energy from this energizer locally energizes the adhesive layer in proximity to the selected die. Thereby the selected die is loosened from the adhesive layer. In the pickup step the pickup tool is controlled to be positioned near the selected die. The pickup tool is then attached to the selected die and the selected die is picked up by the pickup tool. The selected die is then carried away by the pickup tool to a designated destination

### BRIEF DESCRIPTION OF THE DRAWINGS

These and other aspects are described in more detail with reference to the drawings wherein:
FIG 1 shows flow charts of the conventional wafer processing versus a method according to the second aspect of the invention.
FIG 2 shows a prior art structure for picking up a die from a dicing tape, using needles.
FIG 3 shows an embodiment of an active carrier according to the first aspect of the invention.
FIG 4 shows a top view of an active carrier with the dimensions of a wafer.
FIG 5 shows a cross-section of connections in an embodiment of an active carrier.
FIG 6a shows an active carrier releasing a die according to the second aspect of the invention
FIG 6b shows a released die being carried away from an active carrier
FIG 7 shows a schematic graph of adhesive force versus temperature
FIG 8 shows four steps of an embodiment according to the second aspect of the invention.
FIG 9 shows examples of different die arrangements and corresponding energizer arrangements.

### DETAILED DESCRIPTION OF EMBODIMENTS

Other objects, features and advantages will occur from the following description of particular embodiments and the accompanying drawings. These embodiments are described in sufficient detail to enable those skilled in the art to practice the presently disclosed systems and methods, and it is to be understood that other embodiments may be utilized and that structural and logical changes may be made without departing from the spirit and scope of the present system. In the description, identical or corresponding parts have identical or corresponding numerals. The exemplary embodiments shown should not be construed to be limitative in any manner and serve merely as illustration. The schematic symbols and shapes shown in the drawings are only used to illustrate components of the system. No particular limitation in shape, size or appearance is implied. The following detailed description is therefore not to be taken in a limiting sense, and the scope of the present system is defined only by the appended claims. Moreover, for the purpose of clarity, detailed descriptions of well-known devices, circuits, and methods are omitted so as not to obscure the description of the present system.

FIG 1 shows a comparison of the conventional process 110 of producing semiconductor dies 14 from a wafer versus a method 100 according to the second aspect of the invention using an active carrier 1. It is noted that by using the active carrier 1 instead of a combination of a passive carrier and a dicing tape 15, the wafer need not be detached from the carrier and reattached to the dicing tape, thus skipping processing steps D - F, which results in higher throughput and lower CoO. Furthermore the flexibility and accuracy provided by the embedded energizers allow for e.g.:
- different die sizes, e.g. by activating multiple sources per die;
- parallel release of multiple dies;
- accurate release of the adhesive at local positions around the die, e.g. more accurate than by radiating energy externally from the back of the wafer which energy can spread laterally around the carrier;
- avoid damage by energy deposition into the dies, which would e.g. by irradiating only the adhesive, not possible when radiating with an external lamp on top of the dies.

FIG 2 shows the traditional way of pickup of a die 14 that is stuck to an adhesive dicing tape 15 on top of an ejector cap 5 (step H of FIG 1). In this case the stiffness of the die 14 is higher than that of the dicing tape 15. When the needles 6 push the tape and die from below, the higher stiffness of the die keeps it straight while the tape is pulled from the sides and peeled off, being partly held by the surrounding tape and vacuum forces V2 . Once the dicing tape 15 is partly peeled off, laminar forces are reduced enough to allow the pickup tool 4 to pick up the die 14 from the ejector cap 5. Pickup in this case is performed by applying a vacuum V1 through a nozzle of the pickup tool 4. To effectively vacuum suction the die 14, this vacuum needs to be stronger, i.e. lower pressure, than the surroundings. In case the difference in stiffness between die and tape is too low, e.g. with thinner dies, the die will start to curl in substantially the same way as the tape and no edge stresses will occur that initiate peeling. A particular problem occurs when the adhesive strength of the tape is too high and the pushing action of the needles causes the die to bend and stretch thereby causing damage.

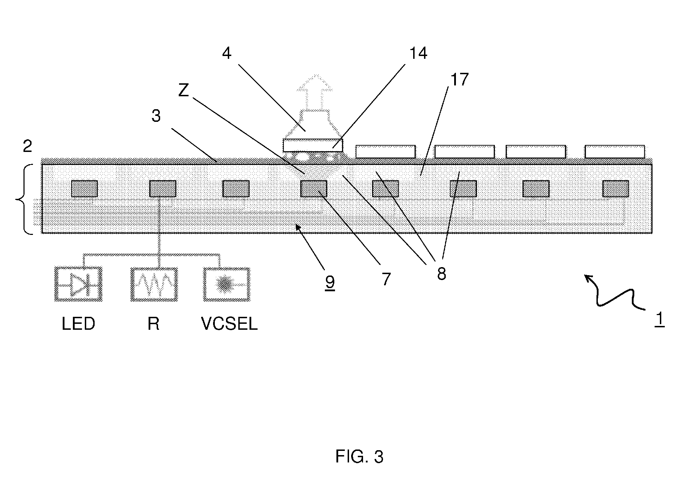

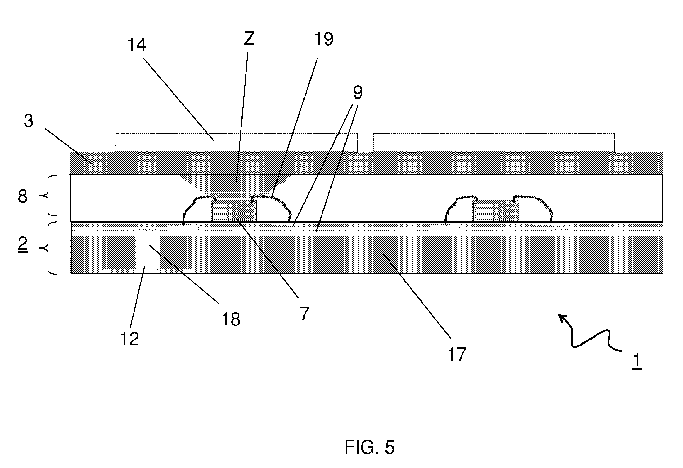

FIG 3 shows an embodiment of a carrier 1 with several dies adhered to an adhesive layer 3 on top of a base plate 2. For each die 14 there is provided, inside the base plate 3, a corresponding energizer 7 capable of emitting energy Z which energizer 7 is embedded inside the base plate 2 and connected through conduction pathways 9 (e.g. wires) to contacts 12 (e.g. contact pads) that are externally addressable (see e.g. FIG 5). These contact pads 12 are preferably embedded on the underside of the carrier. In this way the contacts are in flush, do not stick out from the side of the carrier and do not interfere with the (flat) dimensions of the carrier which is preferably <700 micrometers. The carrier can thus be handled by the (semiconductor) wafer processing machines as a wafer, which is typically dimensioned as a disc of 700 micrometer thickness and a diameter of 200 or 300 mm. Standard device wafer dimensions can be found e.g. in the "SEMI M1 - Specifications for Polished Single Crystal Silicon Wafers".

In the embodiment shown in FIG 3 one energizer 7 is provided per die 14. In an alternative embodiment, an arrangement of energizers 7 corresponding to the die arrangement P is provided where a plurality of energizers 7 is provided per die 14, which energizers can be activated individually or in combination to loosen a selected die 14 from the adhesive layer 3. Alternatively, the energizers can be arranged to also partly energize the adhesive layer or a portion thereof, holding one or more neighboring dies. By pre-energizing the adhesive layer holding these neighboring dies, time can be saved if these neighboring dies are to be loosened in a next cycle.

In an embodiment, the active carrier is supplied with a wafer that is attached to the adhesive layer, e.g. by pressure and/or heating of the adhesive. This heat can optionally be supplied by the embedded energizers. After the wafer is attached to the active carrier, both are supplied to a semiconductor wafer processing machine where the wafer is subjected to various types of processing. E.g. a processing step to reduce the thickness of said wafer through grinding or etching. Other types of processing include: deposition of organic or inorganic layers, thermal treatment, dry and wet etching, resist coating, developing and stripping, lithography, etc.

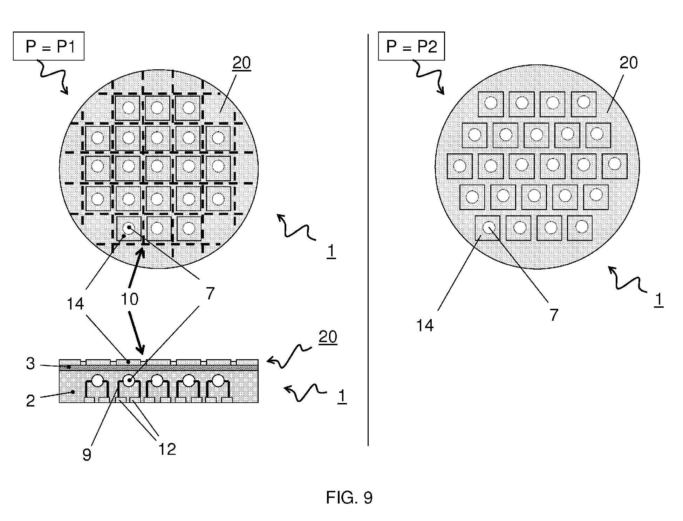

After or during processing, the wafer is cut or partly cut, e.g. by laser application of break lines, to divide the wafer into individual dies in a die arrangement P (see e.g. FIG 9). It is noted that at this point, the individual dies are still attached to the active carrier. This method thus differs from the conventional processing steps because, by using the active carrier, the wafer need not be moved to a separate dicing tape, i.e. steps D - F (see FIG 1) can be skipped.

After dicing, the dies are picked up one by one or in parallel from the active carrier 1. To this end a pickup tool 4 is positioned near (in this case above) a selected die 14 in the die arrangement P and attached to said die 14 using e.g. a vacuum nozzle. A controller 24, attached to the contact pads 12, activates one or more energizers 7 in proximity to the selected die 14 for locally energizing the adhesive layer 3 under the selected die 14 thereby loosening the selected die 14 from the adhesive layer 3. Upon local deactivation of the adhesive layer 3, the die 14 can be picked up by the pickup tool 4 and carried away for placement in a designated position (e.g. a 3D stack).

This local energizing is restricted to a selected portion of the adhesive layer 3 holding the die arrangement P and in particular to the portion of the adhesive layer 3 that holds the selected die 14 to the active carrier 1. By locally energizing only this portion of the adhesive layer, the selected die is loosened while the non-selected dies are not loosened by the activated energizer. This can be accomplished e.g. by facilitating the energy conduction between the energizers and the corresponding dies with an energy conducting material 8, while separating crosstalk between energizers and non-corresponding dies with an energy insulating material 17.

For energizers that operate by emission of radiation, e.g. LEDs (light emitting diode) or VCSELs (vertical cavity surface emitting laser), energy conducting materials 8 are e.g. transparent materials for the emission frequencies of the energizers and energy insulating materials 17 include materials that reflect the emission frequencies of the energizers. Correspondingly, for energizers 7 that operate by emission of heat, e.g. a (thin film) resistor R, energy conducting materials 8 include those materials that conduct heat well and energy insulating materials 17 include materials that have poor heat conduction (e.g. SiO₂). For a heat conducting material, e.g. copper can be used, insulated by a thin (electrically and chemically) passivation layer such as SiO₂.

A conductor 8 comprised of an energy conducting material can also be used to spread e.g. heat or light from a point source energizer 7 over a local surface corresponding to the surface over which the die 14 is attached to the adhesive layer 3.

In a practical embodiment, an active carrier comprises a glass base plate 2 of e.g. 600 - 700 micrometers thickness on top of which a thin layer of circuitry is applied (e.g. thin film resistors and conduction pathways 9). This circuitry is covered by a thin passivation layer. The passivation layer is durable, heat conducting and electrically isolating. A typical thickness for the passivation layer is on the order of 1 micrometer. When the layer is thicker, heat conduction goes down and the carrier could bend due to differences in heat expansion coefficients. An advantage of a glass base plate over silicon is that it is transparent. This allows viewing through the back of the carrier to observe e.g. patterns on an attached wafer for alignment during dicing.

Another advantage of using glass for a base plate is the fact that SiO₂ (which is the main component of glass) has a low heat conduction, making it a good insulator. Heat will thus preferably move through the thin front layer and not the thicker back layer. Additionally, the adhesive could comprise heat conducting elements. The circuitry can be connected to contact pads 12 on the back of the base plate 2, e.g. by creating TSVs. An important consideration in determining the materials for an embodiment of a carrier operating with thermal energizers is that the heat expansion coefficients of the materials match at least within a certain tolerance, e.g. a combination of copper and SiO₂ can be used.

Examples of suitable energy conducting materials 8 that have a higher heat conduction than the traditionally used SiN are silicon carbide (SiC), aluminium nitride (A1N), and diamond-like carbon (DLC). These materials allow a thicker and thus more robust layer while still maintaining adequate heat conduction and electrical insulation. By local processing using e.g. a laser beam such ceramics can glassify i.e. be made amorphous which leads to a reduced heat conductivity. In this way the conductors 8 can easily be dimensioned by transforming borders 17 from a heat conducting material into a more heat insulating material, e.g. to prevent an undesired lateral spreading of heat to neighboring dies that are not selected for loosening.

In a particular embodiment, the energizers comprise a simple resistive element R (e.g. a thin film resistor) that heats up as a result of current flowing through the resistor. This heat can be guided primarily in the direction of the adhesive holding the corresponding die by choosing a conducting material 8 that has a high heat conduction coefficient between the energizer 7 and die 14. Additionally, the flow of energy could be further directed by providing a border 17 of an energy insulating material between the energizers 7 and/or the backside of the base plate 2. Additionally, the resistive elements could be put close to the adhesive layer, possibly on the surface between the base plate 2 and adhesive layer 3.

In another embodiment the energizer could comprise a light emitting energy supply such as e.g. an LED or VCSEL. A particular advantage can be achieved by choosing an emission frequency of said light emitting energy supply such that this frequency does not overlap with absorption bands of an energy conducting (transparent) layer 8 of the carrier between the energizer 7 and die 14. In this way the carrier is not heated up by the emission of the radiating energizer. The light can then be absorbed by the adhesive or die. Additionally if an adhesive is chosen that also transmits the chosen frequency of light, this transmitted light will be primarily absorbed by the die. When the light thus heats up the die, this heat will spread primarily to the underlying adhesive layer that is contacting the die and thus very locally deactivate said adhesive.

An advantage of this heating through the backside of the die is that the heat will be spread from the side of the die into the adhesive layer, thus deactivating the adhesive from the side of the die. The result is that less adhesive will stick to the die than if heat is spread from the carrier side into the adhesive. This has an advantage that less adhesive has to be cleaned from the die and that more adhesive remains on the carrier. Because most if not all of the adhesive stays on the carrier, this adhesive may be reused in a next wafer attachment process. In this case it is particularly advantageous if the adhesive is reusable, e.g. an adhesive cured in a reversible Diels-Alder reaction.

Alternatively if energy deposition in the die is preferably avoided, the light can be tuned to a frequency that is strongly absorbed by the adhesive layer (and not the base plate).

A particular advantage of a VCSEL over an LED particularly for such a case is that the light in a VCSEL is generally more directional and can thus be better aimed to shine primarily at the position of the die. These LEDs and VCSELs can be created in a production method using pick and place from a separate LED/VCSEL wafer.

In yet another embodiment, the energizers 7 could comprise metal pieces that heat up when subjected to microwave radiation. This microwave radiation can be generated e.g. by a maser and coupled into the contacts, e.g. by plasmon coupling or fiber optics, and guided to the energizers 7 using the conduction pathways 9, e.g. a photonic crystal structure. Alternatively, the metal pieces could be part of the adhesive 3 and the energizers 7 could comprise the microwave sources, e.g. solid-state devices such as field-effect transistors, tunnel diodes, Gunn diodes, and IMPATT diodes.

In another embodiment, the adhesive layer could comprise materials, e.g. silica nanopowder, that heat up when subjected to (changing) magnetic fields and the energizers are constructed to emit these magnetic fields, e.g. comprising solenoid circuits.

The energizers can thus comprise all types of energy transducing elements. Alternatively, the energizers could also comprise passive elements, e.g. reflective or refractive elements that guide light to the adhesive layer. This light can be coupled into the contacts by e.g. an external light source such as a laser and guided through the conduction pathways, e.g. (glass fibre) channels or photonic crystals, to the corresponding energizers.

In the embodiment shown in FIG 3, the base plate 2 is a rigid construction, e.g. constructed from a silicon or glass wafer. Alternatively, in another embodiment, the base plate can be flexible, e.g. a flexible foil with circuitry such as resistors and contact pads. An advantage of such a cheap embodiment is that the carrier can be a disposable carrier that could act as grinding tape and/or dicing tape, but with energizing elements embedded in the foil. Because it is disposable, this active carrier foil does not have to be cleaned after pickup. The foil can comprise materials similar to a grinding or dicing tape so that the carrier/foil can be handled by the existing equipment for dicing/grinding tape handling. Especially suitable for a disposable embodiment, the energizers could comprise a substance capable of an exoergic reaction, e.g. a substance that undergoes an exothermic reaction when triggered at the appropriate time, e.g. through radiation.

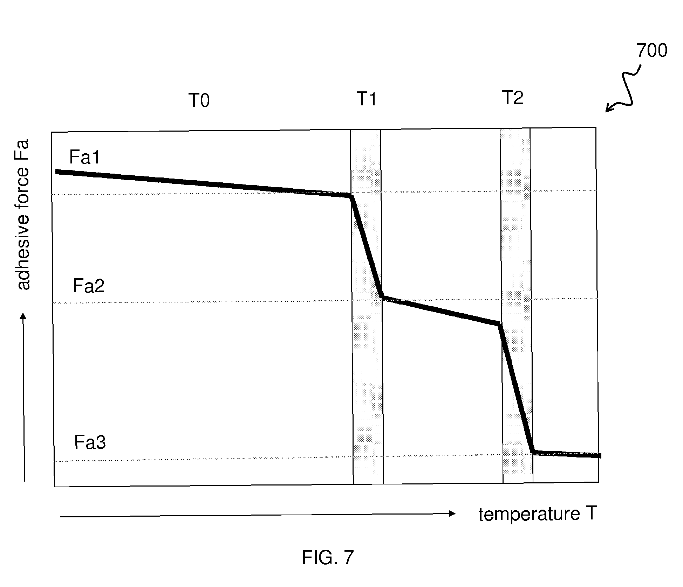

In an embodiment, the adhesive layer comprises a material whose adhesive properties can be locally deactivated e.g. it changes viscosity in a deactivation temperature range T1 as shown e.g. in FIG 7. By heating the material to said temperature range T1, the viscosity is changed such that the adhesive force (Fa) is lowered substantially.

In an embodiment of the invention, deactivation of the adhesive force (Fa) results from deactivation of an adhesive cured through a Diels-Alder chemical reaction. In a Diels-Alder reaction, cross-links are formed between two functional groups A and B. In particular, the deactivation of an adhesive cured through a Diels-Alder chemical reaction involves the heating of the adhesive to a temperature at which at least part of the cross-links cleave thus leading to a reduction of the adhesive properties of the adhesive. The deactivated adhesive preferably has a viscosity of at most 500 Pa-s, as measured e.g. by oscillatory measurements on an Anton Paar MCR 301 rheometer using parallel plate geometry, disclosed in W02010/044661;

In an embodiment, the functional groups A comprise diene groups, and the functional groups B comprise dienophile groups. Preferably, the total amount of the functional groups A and the total amount of the functional groups B are essentially in the proportion of 1/1 (A/B). The amount and type of the functional groups A and B to be used depend on the desired properties of the adhesive (strength, transition temperature, etc.). Examples of functional groups A are furane, anthracene, thiophene and/or pyrrole groups. Examples of groups B are maleimide, fumarate, maleate and/or alkyne groups.

Such Diels-Alder chemical reactions are known in the art. For example, WO2004076567 discloses a low solvent coating process with an embodiment, wherein the covalent bond between two functional groups (a diene and a dienophile) is brought about by means of a Diels-Alder reaction. WO2010044661 discloses a method for recycling an organic-matrix composite material with an embodiment wherein thermo-reversible cross-links are at least in part based on a reversible Diels-Alder reaction. Yet another example of Diels-Alder reactions can be found in an article by Magana et al. in Reactive & Functional Polymers 70 (2010) 442-448. Each of these examples is incorporated herein by reference in its entirety.

An adhesive cross-linked through a Diels-Alder reaction forms a chemically cured adhesive. In a Diels-Alder reaction, when heat is applied, cross-links are opened thus creating a non-cross-linked system. This opening of the cross-links typically results in a liquefying of the adhesive leading to a lowered adhesive force. The Diels-Alder adhesive changes within a relatively narrow temperature range from a solid into a low-viscous liquid. This is in contrast to the conventional thermoplastics and waxes that are used to deactivate the adhesive properties of a whole wafer (step D of FIG 1).

The narrow temperature range of the Diels-Alder reaction is particularly advantageous in preventing that nearby dies are involuntarily detached due to e.g. heat spreading along the carrier surface from the designated area.

In addition, the cured adhesives are able to withstand higher mechanical stress due to their naturally present chemical crosslinks. The dies are chemically better bonded at low temperature when they should be bonded (e.g. during grinding) and more easily released when they should be released (e.g. during pickup).

As yet another advantage, the transition temperature Tg of a Diels-Alder reaction can be tuned by e.g. adjusting the number of Diels-Alder components in the adhesive, adjusting the molecular weight of the polymer in between the Diels-Alder compounds and/or by changing the crosslink density of the adhesives by adding a second crosslink compound such as an epoxy, polyurethane, amine, acidic compound.

In another aspect, the adhesive is of a thermally reversible nature - that is, the adhesive comprises cross-links that are opened or closed in a thermally reversible way. Such thermally reversible reactions are known in the art, e.g. from WO2010044661 and WO2004076567, which are incorporated herein by reference. The thermoreversible cross-links can be based on a number of mechanisms, such as an ionic bond, a hydrogen bond, a Diels-Alder reaction, nitroso dimerisation, ester formation (such as cyclic anhydride reactions in which ester bonds are formed), ionene formation, urethane formation, azlactone-phenol adduct formation, metal-ligand coordination, or combinations thereof. The thermally reversible reactions can be chosen e.g. from the following group of reactions: Diels-Alder (cycloaddition) reactions; Michael reactions; nitroso dimerization reactions, cyclic anhydride reactions in which ester bonds are formed; reactions in which aliphatic ionene formation takes place; reactions in which urethane formation takes place, and reactions in which azlactone-phenol adduct formation takes place. A condition is that the reaction chosen from this group is thermally reversible.

For a further description of these reactions, reference is made to J. Macromol. Sci. Rev. Macromol. Chem. C33 (3), 1993, pp. 239-257; Science 1 March 2002: Vol. 295. no. 5560, pp. 1698 - 1702; Polymer 51 (2010) 1169-1175; Polym. Degrad. Stab. 2010, 95, 826-829;Composites Science and Technology Volume 69, Issues 7-8, June 2009, Pages 1082-1087.

In an advantageous embodiment, the thermally reversible reaction is based at least in part on a reversible Diels-Alder reaction in which the cleaving of cross-links is thermally reversible. Making use of (thermally) reversible reactions in the deactivation of the adhesive layer allow for an embodiment of a carrier comprising a reusable adhesive layer 3. In such an embodiment it is furthermore advantageous that most of the adhesive remains on the carrier and does not stick to the die. To achieve this, the adhesive can be heated from the backside of the die, e.g. by a radiating energizer that radiates through a transparent adhesive layer onto the die as mentioned earlier.

In an example Diels-Alder reaction, a furfuryl containing compound is reacted with a maleimide containing compound. An example of an adhesive build-up is a bismaleimide compounds that is reacted with a butylmethacrylate furfuryl-metacrylate (BMA-FMA) co-polymer.

By way of example (example A) only and not limiting to the disclosure of this application, a preparation of a BMA-FMA co-polymer (ratio 9:1) was performed as follows. In an atmosphere of nitrogen, 10.398 g (73.125 mmol) of butyl methacrylate (BMA; Aldrich) and 1.350 g (8.125 mmol) of furfuryl methacrylate (FMA; Aldrich) are dissolved in 45 ml of toluene, followed by the addition of 133.4 mg (0.8125 mmol) of 2,2'-azobis(2-methylpropionitrile) (AIBN; Fluka). The resulting solution is stirred at 90°C for 20 hours. After cooling to room temperature, the mixture is added to 250 ml of methanol under vigorous stirring in 30 min, followed by an additional 0.5 hour stirring. After standing overnight, the hazy solution is decanted from the sticky, precipitated polymer. The product is then stirred with 250 ml of methanol for one hour. After removal of the methanol, the polymer is dried in vacuum at 80°C overnight. Yield: 9.71 g (73.3%) of a colourless viscous solid.

This product was characterized by proton-Nuclear Magnetic Resonance (¹H NMR), Gel Permeation Chromatography (GPC), and Differential Scanning Calorimetry (DSC). The ¹H NMR results: chemical shift δ (CH₂O-BMA) = 3.94 ppm (parts per million) and δ (CH₂O-FMA) = 4.94 ppm; The integration BMA:FMA is approximately as started with. GPC results: number average molecular weight Mn = 24786, weight average molecular weight Mw = 46073, and polydispersity index PDI = 1.86. With DSC a glass transition temperature Tg ∼ 36.8°C is found in the first run and Tg ∼ 33.2°C in the second run. This indicates a reversible Diels-Alder reaction.

In yet another example (example B) a co-polymer BMA-FMA (9:1) plus BMI-H is prepared as follows. 1 g (0.6924 mmol) of co-polymer BMA-FMA (9:1) and 0.134 g (0.3739 mmol) of 1,1'-(methylenedi-4,1-phenylene) bismaleimide (BMI-H; Aldrich) are dissolved in 10 ml of CH₂Cl₂. After stirring for 15 min, the solution is slowly evaporated to dryness at room temperature. The residue is dried in vacuum (1 mm Hg) for 24 hours. Yield: 1.13 g of a light yellow solid. The thermal characteristics of this solid are studied by DSC: thrice heating to 150°C (3°C/min), cooling down to -50°C (3°C/min), heating again to 150°C. Using DSC the following results are obtained for this sample: in all runs the Tg remains between 57 and 60°C, indicating the occurrence of a lasting reversible Diels-Alder reaction between the FMA-groups of the polymer and BMI-H.

In an advantageous embodiment the transition temperature Tg is tuned such that the adhesive does not deactivate when exposed to the environmental (temperature) conditions of the wafer processing machine, i.e. Tg is higher than the temperatures reached during processing. This way the carrier can participate in all steps of the (thin) wafer processing.

For example, the transition temperature Tg can be raised by adding substituent to the furane group that cause steric hindrance and/or electronic effects that partially hamper the Diels-Alder reaction, with the result that the reaction takes place at a higher transition temperature.

Furthermore, a less brittle bonding of the adhesive at room temperature can be achieved by replacing BMA (butylmethylacrylate) with BA (butylacrylate). For example, in the case of analogous methylacrylate-and acrylate polymers, the acrylate polymers generally have a lower transition temperature Tg. For a specific molecular weight, the transition temperature can thus be adjusted by specifying the relative amounts of BMA/BA. Other possibilities for changing the transition temperature include the adjustment of the number of cross-links (e.g. less FMA) and/or using shorter polymer chains or using a different BMI.

In further advantageous embodiment, to reach a lower viscosity at the debonding or transition temperature, the polymer compounds used in the Diels-Alder reaction are replaced with relatively small di- and/or tri-furane compounds combined with relatively small di- and/or tri-maleimide compounds. These smaller compounds still form polymers in the Diels-Alder reaction but break down into smaller molecules after debonding which provides a viscosity that is tunable to a very low value.

In an embodiment of the invention shown in FIG 3, the adhesive layer 3 comprises a gas generating agent that is activated when heated to a second temperature range T2 and forms gas within the adhesive, creating bubbles. Alternatively the gas forming agent could be activated when irradiated with light, e.g. ultraviolet light. The expansion of these bubbles causes active delamination of the die by a combination of expansion forces and reduction of squeeze forces. Suitable gas forming agents are those that can be dissolved into the adhesive.

Preferably, the adhesive and gas forming agent are chosen such that the first temperature range T1 is lower than the second temperature range T2 so that, when the adhesive is heated up, it first undergoes a viscosity change and subsequently gas is released into the adhesive. This change of viscosity allows better expansion of the bubbles. Alternatively, if the gas generating agent is activated by irradiation, the energizers could comprise both heating elements and radiating elements to independently control the temperature of the adhesive and the gas forming process. Alternatively the active carrier comprises different types of energizers where multiple energizers work together to loosen a selected die.

Various ways are known for introducing bubbles into substances. For example, US4925684 discloses a method for opening microwave packages using metal flakes which are heated up by microwave radiation in close proximity to a heat-releasable resin containing a blowing agent. When the resin becomes hot it causes the blowing agent to decompose and form a gas.

In another example, US2007/0037364 discloses azo compounds and azide compounds as gas generating agents. These azo compounds generate nitrogen gas when exposed to radiation, particularly with a wavelength of about 365 nm.

In yet another example, polymeric microcapsules can be added to the adhesive with a low-boiling point where the polymeric shell dissipates at certain temperatures. Alternatively, water crystallized in salts could be introduced into the adhesive, e.g. hydrates such as MgSO4.7H2O or evaporation of adsorbed water, e.g. Zeolites.

WO0040648 discloses a debondable adhesive composition that can enhance the heat resistance of the adhesive and that can effectively reduce peel strength after a heat treatment. The heat debondable adhesive composition comprises a curable resin and a heat expandable material, wherein the heat expandable material is a heat expandable inorganic material. In JP6184504 an adhesive is prepared by compounding an adhesive with at least two types of thermally expandable fine particles having mean particle diameters different from each other by at least 3 micrometers.

Other materials suitable for the adhesive include azodicarbonamides, hydrazinederivates, semicarbazides, tetrazoles, expandable graphite, vermiculite, pearlite, mica, wermlandite, thanmasite, hydrotalcite. Expancel supplied by Akzo Nobel, Micropearl supplied by Matsumoto.

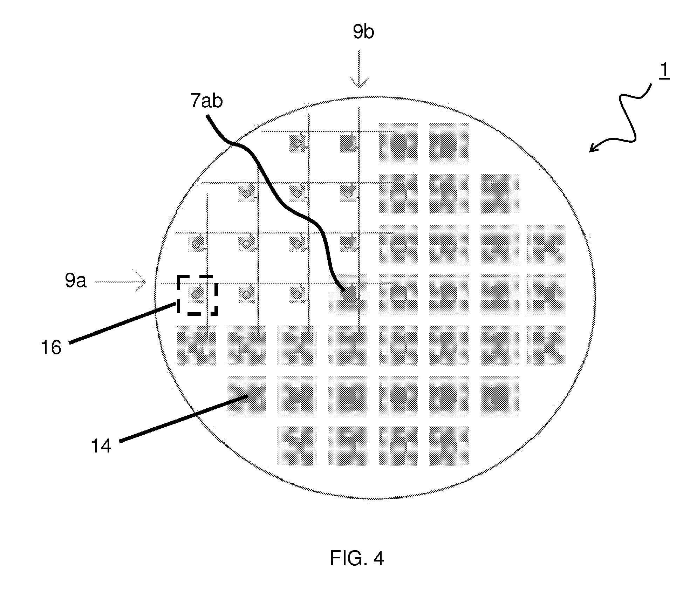

FIG 4 shows a top view of an active carrier 1 shaped in the form of a wafer, with partly empty positions 16 where the dies 14 have been picked up, showing the underlying energizers 7 that are connected through a matrix of intersecting conduction pathways 9. In this embodiment each wire (which connects to multiple energizers) has a corresponding contact pad. A designated energizer can be powered by applying a voltage differential over the corresponding pair of wiring, e.g. energizer 7ab is powered by supplying a voltage differential over wires 9a and 9b. An advantage of this matrix wiring is that the number of contact pads can be kept lower compared to a situation where each energizer has its own pair of contact wires and pads.

To allow for easy processing of the carrier plus wafer it is especially advantageous that the carrier is dimensioned such that, when carrying a thinned wafer, this combination can structurally fit in a semiconductor wafer processing machines, that is, the combination can be fit for processing in semiconductor wafer processing machines and conventional methods for handling and processing of wafers can be used also for thin wafers/dies. In this way, no (costly) adjustments will have to be made to the processing machinery.

Dicing on a die-by-die basis, just before pick-up, creates flexibility in the process flow and avoids handling of a diced wafer. The number of manufacturing operations is reduced resulting in improved yield. Cycle time is reduced leading to higher throughput.

Furthermore, the materials and properties of the base plate (including energizers) and adhesive need to be chosen such that they can withstand the processing conditions of the wafer (e.g. grinding, backside processing, etc.). For robustness of the active carrier it is advantageous to embed one or more of the energizers 7, contact pads 12, and conduction pathways 9 inside the base plate. To protect e.g. the energizers from the heat and/or radiation conditions in the wafer processing machine, they could e.g. be insulated by a heat/radiation resistant material.

A further advantage may be achieved by a method to produce a carrier according the first aspect of the invention wherein the base plate 2 and corresponding energizers 7, contacts 12, and conduction pathways 9 are created from a wafer using standard lithographic techniques.

First, a lithographic processing machine is supplied with a wafer and controlled to produce onto said wafer a plurality of energizers (e.g. thin film resistors), a plurality of contact means (e.g. contact pads), and conduction pathways connecting said energizers to corresponding contact means.

The pattern of energizers is laid out in a two dimensional pattern such that these source can locally supply energy (e.g. heat, radiation) to a designated die when the active carrier is in use according to the second aspect of the invention. In an embodiment according to the first aspect of the invention there could be more than one energizer supplied per die, working in conjunction to supply the required energy.

The option to individually or in combination activate only designated energizers near specific areas of the adhesive layer allows for greater flexibility with respect to e.g. different die sizes or when handling multiple pickups in parallel. Also the amount of energy that is deposited in specific areas can be carefully controlled. An additional advantage is achieved when using an embedded energizer since the flow of energy can be managed by adjustment of the surrounding materials. For example when using a resistive element as energizer, the heat that is generated can be accurately guided by choosing a combination of heat conducting and heat isolating materials in the base plate. Similarly, when using a radiating element, the surrounding material can be chosen to be e.g. transparent between the energizer and the designated die, while being reflective elsewhere.

In an embodiment a carrier is produced from a wafer by creating a two-layer interconnect structure in combination with thin film resistors which can be created using standard lithographic or laser machining techniques. An advantage of resistors such as thin film resistors is their generally high tolerance for elevated temperatures, such as may occur e.g. during particular wafer processing steps.

Starting from a standard wafer a pattern of interconnecting wiring is created using e.g. plasma enhanced chemical vapor deposition (PE-CVD), including the following steps:
- apply (photo)resist to the wafer
- apply a lithographic pattern
- develop the (photo)resist
- etch the pattern into the wafer
- strip away the remaining resist
- metal deposition, e.g. a copper Damascene process, comprising the steps of sputtering a seed layer, plating, and chemical-mechanical planarization (CMP) to remove the copper to the level of the top of the insulating layer.

Conductive material sunken within the trenches of the insulating layer becomes the patterned conduction pathways and/or thin film resistors that can be used as the energizer to locally heat up the adhesive. These steps can be repeated e.g. 4-6 times to create a layered structure of interconnecting (copper) wiring such as shown e.g. in FIGs 3-5.

For contact between the different layers a number of vias (vertical pathways) can be created e.g. by using laser techniques to create plurality of holes and filling these holes with conducting material, e.g. paste. To keep the production costs low it is further advantageous to keep the aspect ratio of the vias small. Similarly, external contacting means can be applied, preferably to the underside of the carrier to maintain the proper dimensions for the carrier.

Alternatively, energizers such as LEDs or VCSELs can be pick and placed from a separate LED/VCSEL wafer, e.g. using attach and wire bonding techniques (shown e.g. in FIG 5). An advantage of LED/VCSEL is that they can be tuned to selectively only shine their energy onto the bottom of a designated die instead of the corresponding adhesive layer, thus producing a more local deactivation of the adhesive layer that is directly connected to the die. A particular advantage of VCSELs is that the emitted light can be more accurately directed to the die.

Furthermore the active carrier is designed to be able to withstand the environmental conditions of the processing machine (temperature, etc.). This means that the materials of the base plate, including the energizers, are selected for their environmental resistances, depending on the processing steps that they need to endure. Similarly an adhesive is chosen that is strong enough to hold the wafer also during e.g. a grinding step. An example of a passive carrier using a heat soluble adhesive is shown in US2005164472. An example of a dicing tape using a gas generating agent is shown in US2007037364. A method for wafer attachment using electrostatically generated holding forces is shown in US2004037692.

FIG 5 shows a side view cross section of an embodiment of an active carrier 1. In this embodiment conducting pathways 9 have been implanted into an insulating layer 17 of base plate 2, e.g. through lithographic techniques. These pathways 9 are connected to contact pads 12 with TSVs 18, created e.g. through laser perforation and filling. In this embodiment the pathways 9 are connected through wiring 19 to an energizer 7 using e.g. a pick and place techniques, followed by attach and wire bonding techniques. Subsequently the base plate is filled up with an energy conducting layer 8 thereby finalizing the base plate 2 with a flat top surface. Subsequently an adhesive layer 3 is applied which completes the production of an active carrier 1. In use, an active carrier can hold a wafer or a plurality of cut dies 14 stuck onto its adhesive layer 3.

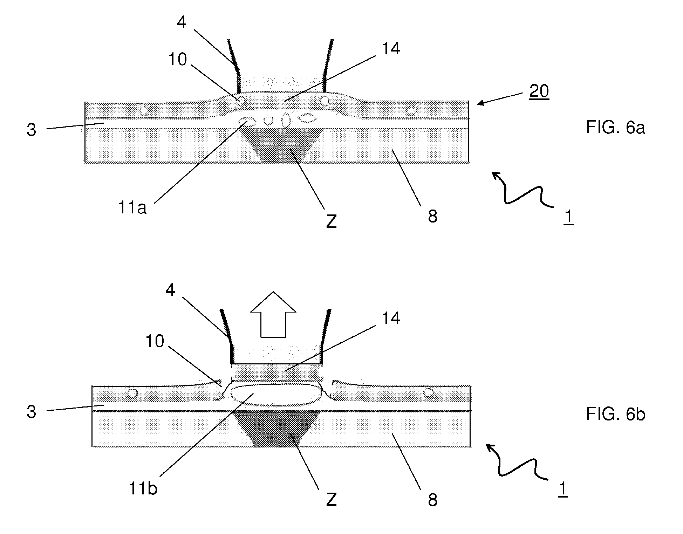

FIG 6a shows the top part of an embodiment of an active carrier in a first stage of a die detachment process where a pickup tool 4 is attached to the die. By influx of energy Z from the underlying energizer 7 through a transparent layer 8 into the adhesive layer 3, bubbles are generated that start pushing up the overlaying die. In this embodiment, the die is formed from a wafer through a stealth dicing technique whereby break lines 10 are applied to the wafer (e.g. using a laser cutter) in a pattern corresponding to the cut lines of the dies. E.g. US2008280421 discloses a wafer dividing method that includes a modifying layer forming step in which a laser beam with a wavelength that can pass through the wafer is focused on the inside of the wafer from a rear surface side thereof

A particular advantage is achieved by combining this partial dicing technique with the gas forming agent as shown in FIG 6b. In a later stage of a die detachment process the generated bubbles 11a uniformly push up the die 14, whereby the expansion forces of the gas cause a breakage along the break lines 10 thereby detaching the die 14 from the wafer 20 along the preformed break lines 10. Additionally, the generated bubbles 11a may coalesce to form a larger bubble 11b that uniformly pushes up the die 14. This uniform lifting means a reduction of stresses on the die 14 compared to other techniques such as e.g. using a needle 6 or only dissolving the adhesive and simply pulling it with the pickup tool 4, thus preventing damage. In another embodiment, the break lines 10 could also be extended (partly) into the adhesive layer thereby limiting the migration of bubbles through the adhesive layer only to the relevant designated die. The application of bubbles is thus fully compliant with laser dicing for thin wafers (thickness < 50 micrometers). For these thin wafers, e.g. saw dicing leads to problems with cracking, chipping, and other yield and quality issues.

FIG 7 shows a schematic graph 700 of an adhesive force Fa that is applied to a die as a function of temperature T. Starting out with a nominal adhesive force Fa1 in a nominal temperature range T0, the adhesive force in this example is significantly reduced, e.g. by a viscosity that is lowered about 10 fold over a temperature range of e.g. 10 -50 K when entering a first temperature range T1 to an intermediate value Fa2, e.g. because the adhesive undergoes a phase transition, e.g. melting, evaporation or sublimation. For example, in a temperature range T1 may be about 120 - 180 °C; and a lowering of viscosity is provided from 0(1000) - 0(1) Pa.s in a range of 60 °Cor even a lowering from O(1000)-O(0.1) in a range of 40 °C.

When the temperature is increased even further to a second temperature range T2, the adhesive force is reduced further to a value of Fa3 which is low enough to initiate pickup of the die from the active carrier. This second reduction of adhesive force could be the result e.g. of a gas generating agent that is incorporated into the adhesive layer and triggered by a certain temperature, e.g. an evaporation temperature. Alternatively, not a temperature but a certain type of electromagnetic radiation initiates the activation of the gas generating agent. In another embodiment, only one of the two mechanisms, either a change in viscosity/phase transition or a gas generating agent, is used.

Weakening of the adhesive in a first temperature range T1 and gas generation in a second temperature range T2 are in principle chemically independent, provided that the gas generating agent is compatible with the adhesive. These temperature ranges can thus be individually tuned. For the current application, it is desired that these temperature ranges T1 and T2 are kept as narrow as possible, and as close together as possible (preferably still T1<T2), thereby preventing that a designated die has yet not fully detached, while nearby dies are also involuntarily starting to detach as a result e.g. of lateral spreading of energy supplied locally to the adhesive.

In an advantageous embodiment, the adhesive layer comprises a thermally switchable adhesive. Such an adhesive has a switching temperature that is well defined in a narrow range, such that the adhesive can be locally heated resulting in the release the designated die without release of the non-designated dies. A suitable thermally switchable adhesive is an adhesive that can be locally energized with heat to release only the designated die(s) and none of the non-designated dies. This property is achieved if the heat gradient and thermal conductance between the designated die(s) and the nearest non-designated die(s) is small enough such that not enough heat transfers to the non-designated dies for loosening said non-designated dies. The thermal gradient can be lowered by using adhesives that switch their adhesive property in a narrow temperature range. The thermal conductance between adhesive layers of different dies can be lowered e.g. by using insulating materials and or barriers.

A switchable adhesive that has been switched-off, e.g. by a phase-change, may still exhibit viscous fluid behavior. A typical viscosity may switch between O(0-10) Pa.s and 0(1000) Pa.s, for example, a debond viscosity of 0-50 Pa.s, preferably as small as 0.1 -2.5 Pa.s and a bond viscosity of for instance 2000 Pa.s. In the disclosed example B a switch between a viscosity of 2000 Pas @ 120 °C and 2.5 Pa.s @ 180 °C is provided.

Through bubble expansion active delamination of the die is caused by both the expansion forces and a reduction of squeeze forces (see e.g. publication 'Challenges in Ultra-thin Die Handling' by Gerald Steinwasser General Manager Mühlbauer, Inc.). The bubbles can be generated by noncontact energizers, for instance optical, thermal or EM radiation. In an alternate embodiment the bubbles can be generated by a contacting source in the from of one or more hollow needles which just penetrate the tape and blow bubbles into the adhesive layer

The main advantage of all the options given above is that the required pick-up force is significantly reduced. Hence, it becomes feasible to pick very thin dies at the high speed that are required to achieve the demanded yield, while using regular vacuum nozzles.

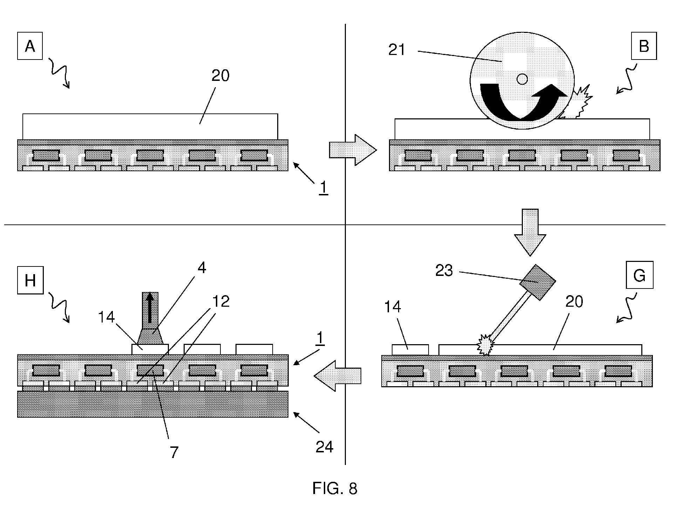

FIG 8 shows four steps of an embodiment of a method according to the second aspect of the invention comprising the following steps. In step A, a thick wafer 20 is adhered to an active carrier 1. In step B, a thick wafer is reduced in thickness by a thinning machine 21, e.g. a grinder or etching machine. In step G, a cutting machine 23, e.g. a laser cutter, is used to cut (dice) the thin wafer 20 into individual dies 14 In step H, the active carrier 1 is attached with its contact pads 12 to a controller 24, which controller can activate a designated energizer 7 that is in proximity to a die 14 e.g. by applying a voltage differential across the corresponding contact pads. Once the energizer 7 is activated and the adhesive layer is deactivated the designated die 14 can be carried away by pickup tool 4, e.g. a vacuum nozzle.

FIG 9 shows two examples of an arrangement P of dies 14 that are obtained from a wafer 20 by application of break lines 10. The underlying carrier 1 has energizers 7 in or on the base plate 2 in an arrangement corresponding to the die arrangement P, i.e. they are arranged such that they can optimally energize the adhesive layer 3 of any selected die 14, thereby loosening said selected die 14. In the embodiments shown each die 14 has a corresponding energizer 7 that is positioned approximately in a central position beneath the die 14. In an alternative embodiment, the correspondence is a many-to-one relation which involves an arrangement of plural energizers per die, which could work together to energize a selected part of the adhesive layer. In yet another embodiment, energizers could be positioned such that they are shared between dies, e.g. below the break lines 10. In the embodiment shown in FIG 9, each energizer 7 has its own pair of conduction pathways 9 and contacts 12. Alternatively these can also be shared between energizers as shown e.g. in FIG 4.

An advantage of an alternating (brick) arrangement, such as P2, over a straight arrangement, such as P1, is that the former generally allows more dies to be cut from a wafer 20. The energizers 7 can correspondingly be arranged to allow for this maximum yield of dies 14 from the wafer 20. However, an advantage of P1 is that the break lines 10 are easier to cut. An advantage of using laser dicing is that the laser can generally be more easily controlled to cut any desired pattern P.

While the invention has been illustrated and described in detail in the drawings and foregoing description, such illustration and description are to be considered illustrative or exemplary and not restrictive; the invention is not limited to the disclosed embodiments. In addition, the components in the disclosed examples are dies in a die placement process, other placement systems which require release and pickup, such as surface mounted devices, MEMS devices etc. can be used without departing from the scope of the invention. Other variations to the disclosed embodiments can be understood and by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. An active carrier (1) for carrying a wafer (20) comprising a die arrangement (P), which active carrier (1) comprises
o a base plate (2);
o a plurality of energizers (7) constructed on or in said base plate (2) and laid out in an arrangement corresponding to the die arrangement (P) for locally energizing of an adhesive layer (3) in proximity to a selected die (14) from said die arrangement (P), thereby loosening said selected die (14) from the adhesive layer (3);
o a plurality of externally addressable contacts (12); and
o conduction pathways (9) connecting said contacts (12) to said energizers (7) thereby allowing individual control over said energizers (7) by addressing said contacts (12).

2. An active carrier (1) according to claim 1, wherein said energizer (7) comprises a resistor (R).

3. An active carrier (1) according to claim 1, wherein said energizer (7) comprises a LED.

4. An active carrier (1) according to claim 1, wherein said energizer (7) comprises a VCSEL.

5. An active carrier (1) according to any of the previous claims, further comprising the adhesive layer (3).

6. An active carrier (1) according to claim 5, wherein said adhesive layer comprises a thermally switchable and/or thermally reversible adhesive (3).

7. An active carrier (1) according to claim 6 or 7, wherein the adhesive comprises cross-links formed in one of a Diels-Alder reaction, Michael reaction, nitroso dimerization reaction, ester forming cyclic anhydride reaction, aliphatic ionene formation reaction, urethane formation reaction, and an azlactone-phenol adduct formation reaction.

8. An active carrier (1) according to any of the claims 5-7, wherein said adhesive layer (3) comprises a gas generating agent that can be activated by said energizers (7).

9. An active carrier (1) according to any of the previous claims, wherein said active carrier (1) additionally comprises an energy conducting material (8) between the energizers (7) and the adhesive layer (3) for conducting energy (Z) of the energizers.

10. An active carrier (1) according to any of the previous claims, wherein said active carrier (1), with a thinned wafer attached, is dimensioned to structurally fit in a semiconductor wafer processing machine.

11. An active carrier (1) according to any of the previous claims, wherein said base plate comprises a flexible foil and the active carrier (1) is a disposable carrier.

12. A method for active release and pickup of a plurality of dies comprising the steps of:
o providing an active carrier (1), a pickup tool (4), a controller (24), and a plurality of dies, said dies being adhered to an active carrier (1) and laid out in a die arrangement (P), which active carrier (1) comprises:
- an adhesive layer (3);
- a base plate (2);
- a plurality of energizers (7) constructed on or in said base plate (2) and laid out in an arrangement corresponding to the die arrangement (P) for locally energizing of an adhesive layer (3) in proximity to a selected die (14) from said die arrangement (P), thereby loosening said selected die (14) from the adhesive layer (3);
- a plurality of externally addressable contacts (12); and
- conduction pathways (9) connecting said contacts (12) to said energizers (7) thereby allowing individual control over said energizers (7) by addressing said contacts (12).
o repeating the steps in any order of
- using the controller (24) to activate at least one energizer (7) in proximity to a selected die (14) from said die arrangement (P) for locally energizing the adhesive layer (3) in proximity to the selected die (14), thereby loosening the selected die (14) from the adhesive layer (3); and
- controlling the pickup tool (4) for
• positioning the pickup tool (4) near the selected die (14);
• attaching the pickup tool (4) to said die (14);
• picking up the selected die (14) with the pickup tool (4); and
• carrying the selected die (14) to a designated destination.

13. A method according to claim 12, preceded by the step of
o providing a wafer that is adhered to the active carrier (1) via said adhesive layer (3) and dicing said wafer (20) into a plurality of dies (14) according to said die arrangement (P).

14. A method according to claim 13, preceded by the step of
o providing a wafer that is adhered to the active carrier (1) via said adhesive layer (3) and processing said wafer (20) in a semiconductor wafer processing machine.

15. A method according to any of the claims 12 - 14, wherein
o the die arrangement (P) comprises a plurality of break lines (10) between the individual dies (14);
o the adhesive layer (3) comprises a gas generating agent; and
o deactivation of the adhesive layer (3) comprises the activation of said gas generating agent whereby the expansion forces of the generated gas cause a breakage along said break lines (10) surrounding a selected die (14) to isolate the selected die from the die arrangement (P).
